# DEMANDE DE BREVET EUROPEEN

(11) **EP 1 111 684 A1**
(43) Date de publication de la demande: **27.06.2001**
(21) Numéro de dépôt: 00410162.2
(22) Date de dépôt: 22.12.2000
(51) Int. Cl.: H01L 29/10, H01L 21/225

(54) **Procédé de fabrication de composants de puissance verticaux**

(30) Priorité: 24.12.1999 FR 9916487
(71) Demandeur: STMicroelectronics SA, 94250 Gentilly (FR)
(72) Inventeur: Roy, Mathieu, 37300 Joue les Tours (FR)
(74) Mandataire: de Beaumont, Michel

(57) **Abrégé**

L'invention concerne un procédé de fabrication d'un composant de puissance vertical sur une plaquette de silicium comprenant les étapes consistant à creuser du côté de la face inférieure du substrat (21) une succession de trous (20) perpendiculaires à cette face ; diffuser un dopant (22) à partir des trous, d'un deuxième type de conductivité, opposé à celui du substrat ; et creuser des trous similaires (25) du côté de la face supérieure du substrat pour délimiter un mur d'isolement et faire diffuser à partir de ces trous un dopant (27) du deuxième type de conductivité à fort niveau de dopage, les trous correspondant au mur d'isolement étant suffisamment proches pour que les zones diffusées se rejoignent latéralement et verticalement.

## Description

La présente invention concerne les composants de puissance de type vertical susceptibles de supporter des tensions élevées.

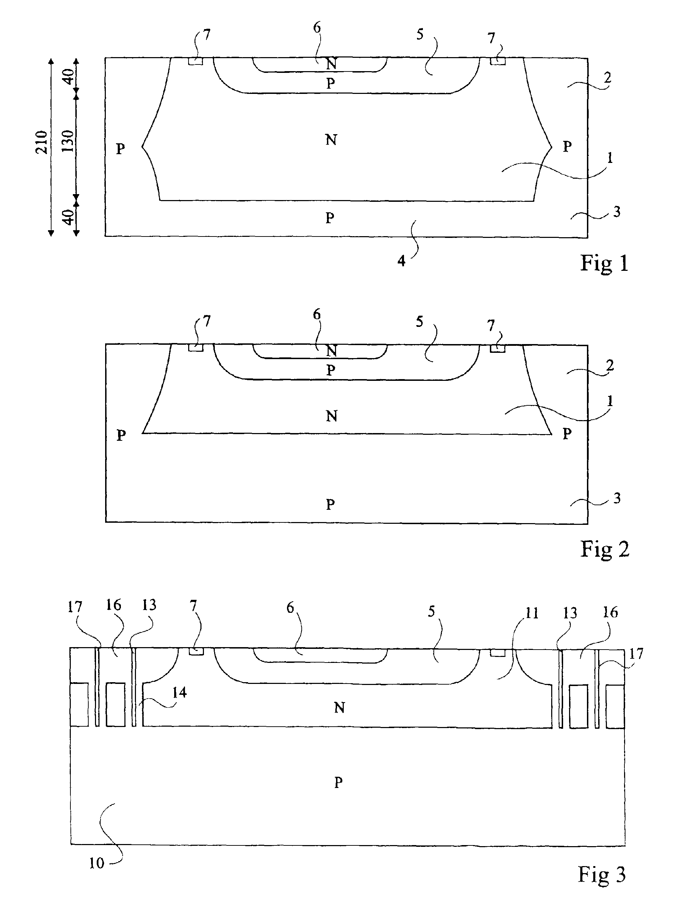

La figure 1 est une vue en coupe très schématique et partielle illustrant l'allure générale d'un composant de puissance classique. Ce composant est formé dans une plaquette de silicium de grande dimension et est entouré à sa périphérie externe d'un mur d'isolement du type de conductivité opposé à celui du substrat. Ce mur d'isolement est destiné à séparer le composant d'autres composants de la même puce, ou à créer une zone de protection électriquement inactive à la frontière d'une puce, là où est effectuée une découpe par rapport à une puce voisine. Plus particulièrement, si l'on considère la figure 1, en partant d'un substrat 1 de type N, une première opération de fabrication consiste à former à partir des faces supérieure et inférieure de ce substrat des régions de diffusion profondes 2 et 3 qui se rejoignent pour former le mur d'isolement.

Pour des raisons pratiques, les plaquettes ne peuvent pas avoir des épaisseurs inférieures à 200 *µ*m. En dessous de ce seuil, elles seraient susceptibles de se briser trop facilement lors des manipulations liées à la fabrication. Ainsi, chacune des diffusions 2 et 3 doit pénétrer dans la plaquette d'une centaine de *µ*m, par exemple 125 *µ*m pour une plaquette d'une épaisseur de 210 à 240 *µ*m, de façon à s'assurer de la formation d'un mur d'isolement continu et suffisamment dopé au niveau de sa partie médiane. Ceci implique des diffusions très longues à des températures élevées, par exemple 300 heures à 1280°C. Il est clair que cette opération doit être réalisée sur une plaquette de silicium avant toute autre opération de dopage de cette plaquette. Sinon, pendant cette longue durée de traitement thermique, les implantations préalablement réalisées dans le substrat diffuseraient trop profondément.

Après formation des murs d'isolement, on forme des régions dopées destinées à former le composant vertical souhaité, par exemple, comme cela est représenté en figure 1, un thyristor. Pour cela, on pourra réaliser simultanément, sur toute la face inférieure du substrat, une région 4 de type P correspondant à l'anode du thyristor et, sur une partie de la face supérieure du substrat, une région 5 de type P correspondant à la région de gâchette de cathode de ce thyristor. Ensuite, du côté de la face supérieure, on réalise une diffusion N⁺ pour former dans la région 5 une région de cathode 6 et éventuellement entre la région 5 et le mur d'isolement 2 un anneau périphérique 7 d'arrêt de canal.

Comme on l'a vu précédemment, l'épaisseur totale de la plaquette est fixée par des considérations de fabrication, essentiellement mécaniques. Par ailleurs, les caractéristiques des régions de type P 4 et 5 sont fixées par les caractéristiques électriques souhaitées du thyristor. En effet, on souhaite par exemple que le front de dopage entre chacune des régions 4 et 5 et le substrat 1 soit suffisamment raide pour améliorer les caractéristiques des jonctions correspondantes, et notamment pour obtenir une bonne caractéristique d'injection du transistor PNP au niveau de la jonction entre le substrat 1 et la région 4, mais pas trop raide pour obtenir un composant suffisamment rapide.

Ainsi, dans le cas du thyristor représenté, si chacune des diffusions 4 et 5 a une profondeur de l'ordre de 40 *µ*m, et si la plaquette a une épaisseur de 210 *µ*m, il restera entre les deux jonctions PN 5-1 et 4-1 une zone du substrat 1 d'une épaisseur de 130 *µ*m. Comme cela est bien connu, c'est cette zone du substrat qui permet de conférer au dispositif de puissance ses caractéristiques de tenue en tension à l'état bloqué. Il faut donc que cette zone soit suffisamment épaisse. Par contre, le fait que cette zone soit trop épaisse entraîne que les pertes à l'état conducteur du dispositif de puissance augmentent. Si l'on veut réaliser un dispositif de puissance ayant une tenue en tension de l'ordre de 400 volts, il suffirait que l'épaisseur de la région de substrat 1 soit de l'ordre de 40 *µ*m alors que, avec le procédé de fabrication décrit, on arrive inévitablement à une épaisseur de l'ordre de 130 *µ*m. On ne connaît pas actuellement de façon simple de résoudre ce problème. En effet, augmenter par exemple l'épaisseur de la couche 4 entraîne que le profil de jonction de cette couche risque de ne pas satisfaire aux conditions électriques souhaitées. Par exemple, si on réalise un thyristor tel que représenté en figure 2 dans lequel la région P de face arrière résulte de la diffusion profonde 3 qui sert à former le mur d'isolement inférieur, on obtiendra une jonction très peu abrupte et les caractéristiques du thyristor seront peu satisfaisantes. En effet l'épaisseur du substrat qui intervient pour déterminer la résistance à l'état passant n'est plus essentiellement l'épaisseur de la région N 1, mais aussi une partie de l'épaisseur de la région P 3. De plus la tenue en tension se dégrade.

De façon plus générale, le même problème se pose avec tout dispositif de puissance devant être entouré d'un mur d'isolement dont la face arrière est d'un type de dopage opposé à celui d'un substrat de tenue en tension, par exemple un transistor de puissance ou un transistor IGBT.

Une première solution pour résoudre ce problème a été proposée par la demanderesse dans la demande de brevet français non publiée N° 99/14012 (B4440) déposée le 3 novembre 1999 qui décrit une structure telle que représentée en figure 3.

Sur un substrat 10 de type P relativement fortement dopé est formée par épitaxie une couche 11 de type N faiblement dopée destinée à constituer la couche de tenue en tension d'un composant de puissance vertical dont le substrat P constitue l'anode. Un mur d'isolement est réalisé en formant une tranchée 13 traversant sensiblement l'épaisseur de la couche épitaxiale 11 et entourant le composant puis en remplissant la tranchée de silicium polycristallin fortement dopé de type P et en effectuant une étape de diffusion thermique.

La tranchée peut être constituée d'ouvertures suffisamment proches les unes des autres pour que les zones diffusées 14 s'étendant latéralement à partir de ces ouvertures se rejoignent et constituent le mur d'isolement. Les ouvertures peuvent par exemple avoir un diamètre de l'ordre de 1 à 5 *µ*m et être distantes les unes des autres de 2 à 10 *µ*m.

Ensuite, on formera de façon classique des diffusions destinées à former un composant souhaité, par exemple une diffusion 5 de gâchette de cathode et des diffusions 6 et 7 de cathode et d'anneau d'arrêt de canal. De préférence, pour améliorer la qualité du mur d'isolement, en même temps que l'on forme la diffusion 5 de type P, on pourra procéder à une diffusion dans des zones 16 correspondant à la partie haute du mur d'isolement, pour augmenter le niveau de dopage à la surface supérieure du mur d'isolement.

Un deuxième mur d'isolement 17 peut être prévu à l'extérieur du premier. Une découpe pourra être effectuée entre les deux murs d'isolement distants par exemple de 100 *µ*m pour séparer deux puces d'une plaquette.

La solution ci-dessus n'est pas toujours satisfaisante car on n'est pas maître du gradient de dopage à la jonction entre le substrat 10 et la couche épitaxiée 11. De plus, cette solution n'est pas adaptée au cas de plus en plus fréquent dans lequel on souhaite réaliser des zones diffusées spécifiques du côté de la face arrière.

Ainsi, un objet de la présente invention est de prévoir un nouveau procédé de fabrication de composants de puissance destiné à optimiser l'épaisseur de la couche la plus faiblement dopée de tenue en tension, à éviter les étapes de diffusion très longues, et à permettre d'optimiser le gradient de dopage entre anode et substrat.

La présente invention vise aussi un composant obtenu par le procédé décrit.

Pour atteindre ces objets, la présente invention prévoit un procédé de fabrication d'un composant de puissance vertical sur un substrat constitué d'une tranche de silicium faiblement dopé, comprenant les étapes consistant à creuser du côté de la face inférieure du substrat une succession de trous perpendiculaires à cette face ; diffuser un dopant à partir des trous, d'un deuxième type de conductivité, opposé à celui du substrat ; et creuser des trous similaires du côté de la face supérieure du substrat pour délimiter un mur d'isolement et faire diffuser à partir de ces trous un dopant du deuxième type de conductivité à fort niveau de dopage, les trous correspondant au mur d'isolement étant suffisamment proches pour que les zones diffusées se rejoignent latéralement et verticalement.

Selon un mode de réalisation de la présente invention, les dimensions des ouvertures et les durées de diffusion de dopants sont telles que les régions dopées s'étendant latéralement à partir de chaque ouverture soient distantes les unes des autres de 10 à 30 *µ*m.

Selon un mode de réalisation de la présente invention, les ouvertures ont un diamètre de l'ordre de 5 *µ*m et sont distantes les unes des autres d'environ 20 à 50 *µ*m.

La présente invention prévoit aussi un composant de puissance vertical de puissance comportant un substrat constitué d'une tranche de silicium faiblement dopé d'un premier type de conductivité opposé à celui d'un substrat faiblement dopé de tenue en tension, comprenant du côté de sa face inférieure une succession de trous parallèles perpendiculaires à cette face inférieure et remplis d'un dopant du deuxième type de conductivité, et dans lequel la périphérie du composant est également percée du côté de la face supérieure de trous remplis d'un dopant du deuxième type de conductivité, les zones diffusées se rejoignant à la périphérie du composant.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 est une vue en coupe schématique d'un exemple de composant de puissance vertical de structure classique ;
la figure 2 est une vue en coupe schématique d'un autre exemple de composant de puissance vertical classique ;
la figure 3 est une vue en coupe schématique d'un autre exemple de composant de puissance vertical ;
la figure 4 est une vue en coupe schématique d'un exemple de composant de puissance vertical obtenu par le procédé selon la présente invention ; et
les figures 5 et 6 sont des vues de dessous partielles de divers exemples de réalisation d'un composant de puissance vertical selon la présente invention.

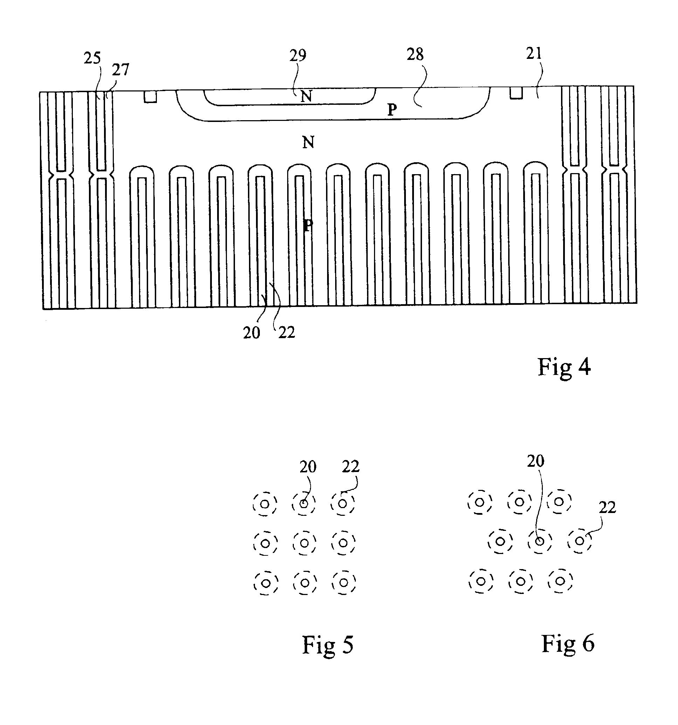

La figure 4 représente une vue en coupe schématique d'un exemple de thyristor selon la présente invention.

Ce thyristor est constitué à partir d'une plaquette de silicium 21 faiblement dopée de type N, similaire aux plaquettes 1 des figures 1 et 2, et à la plaquette 11 de la figure 3.

Du côté de la face inférieure de la plaquette 21 sont formés de nombreux trous 20 ayant par exemple un diamètre de l'ordre de 5 *µ* m. Un dopant de type P est amené à diffuser à partir de ces trous pour former autour de chaque trou une couronne 22 dopée de type P. De façon classique, ce dopage pourra être réalisé en effectuant un dépôt conforme de silicium polycristallin dopé de type P par voie chimique en phase vapeur de façon à remplir les trous puis en procédant à un recuit.

La périphérie du dispositif est traitée comme la périphérie décrite en relation avec la figure 3, en réalisant à partir de la face supérieure des tranchées, ou des successions de trous, 25 également remplies de silicium polycristallin de type P qui diffuse pour former des zones périphériques 27. Les zones diffusées 27 du côté de la face supérieure forment un contour continu et viennent se confondre des zones diffusées correspondantes formées à partir de la face inférieure qui forment un contour continu correspondant.

Diverses variantes de perçages et de modes de réalisation des murs d'isolement apparaîtront à l'homme de l'art et certaines d'entre elles sont déjà connues dans la technique et par exemple décrites dans la demande de brevet français de la demanderesse N° 98/13544 du 23.10.1998 (B4124).

Egalement, du côté de la face supérieure, on a formé une région de type P 28 qui contient une région de type N 29. Ainsi, dans le mode de réalisation représenté, on a obtenu un thyristor vertical dont la cathode correspond à la région 29 et dont l'anode correspond aux régions P 22.

On notera qu'en pratique les régions diffusées 22 ne doivent pas nécessairement être jointives car, quand un champ inverse intense est appliqué, les équipotentielles ne pénètrent pas entre les doigts dopés de type P si ceux-ci sont suffisamment proches les uns des autres, par effet d'auto-blindage, d'une façon connue de l'homme de l'art.

La profondeur des trous 20 est choisie pour que, après formation des zones diffusées 22, la distance verticale entre la jonction entre les régions 21 et 28 et les jonctions entre la région 21 et les régions 22 soit adaptée à la tension que l'on souhaite que le dispositif puisse supporter.

On notera que le gradient de dopage à la jonction dépend des conditions de dopage et de recuit du silicium polycristallin contenu dans les tranchées 20. Ce dopage peut donc être optimisé en fonction des objectifs recherchés.

Le procédé de fabrication décrit précédemment est particulièrement simple à mettre en oeuvre par rapport aux procédés antérieurs, et notamment au procédé décrit en relation avec la figure 3 car la même technologie (perçage de trous) est employée pour réaliser les murs d'isolement et la région d'anode.

Les figures 5 et 6 représentent des exemples de disposition des trous 20 en vue de dessous. L'homme de l'art pourra choisir toute disposition désirée. Comme on l'a indiqué précédemment, la distance entre les trous sera choisie pour que les zones 22 diffusées à partir de trous adjacents se touchent ou non. La première configuration sera choisie dans la région des murs d'isolement.

On a représenté à titre d'exemple et par souci de simplification un thyristor en figure 4. Bien entendu, l'invention s'appliquera également à toute autre structure de composant de puissance de type vertical dont la face arrière est de type opposé à celui d'une couche de tenue en tension, et notamment à des structures de type transistors de puissance et transistors bipolaires à grille isolée (IGBT). Dans de telles structures, la présente invention permet d'obtenir une couche de tenue en tension ayant exactement l'épaisseur souhaitée, ne dépendant pas de contraintes technologiques.

Les durées nécessaires aux diverses diffusions seront extrêmement courtes par rapport à la durée nécessitée pour la diffusion profonde verticale des murs d'isolement décrits en relation avec les figures 1 et 2.

La présente invention est susceptible de nombreuses variantes et modifications qui apparaîtront à l'homme de l'art. Par exemple, on pourra prévoir une étape de rodage de la face arrière des plaquettes après dépôt de la couche de silicium polycristallin remplissant les trous 20.

A titre d'autre variante, au lieu de prévoir des trous voisins du côté de la surface inférieure, on pourra procéder au creusement de tranchées, bien que cette solution ne soit actuellement pas préférée.

## Revendications

1. Procédé de fabrication d'un composant de puissance vertical sur un substrat constitué d'une tranche de silicium faiblement dopé, comprenant les étapes suivantes :
creuser du côté de la face inférieure du substrat (21) une succession de trous (20) perpendiculaires à cette face ;
diffuser un dopant (22) à partir des trous, d'un deuxième type de conductivité, opposé à celui du substrat ; et
creuser des trous similaires (25) du côté de la face supérieure du substrat pour délimiter un mur d'isolement et faire diffuser à partir de ces trous un dopant (27) du deuxième type de conductivité à fort niveau de dopage, les trous correspondant au mur d'isolement étant suffisamment proches pour que les zones diffusées se rejoignent latéralement et verticalement.

2. Procédé selon la revendication 1, caractérisé en ce que les dimensions des ouvertures et les durées de diffusion de dopants sont telles que les régions dopées s'étendant latéralement à partir de chaque ouverture soient distantes les unes des autres de 10 à 30 *µ*m.

3. Procédé selon la revendication 2, caractérisé en ce que les ouvertures ont un diamètre de l'ordre de 5 *µ*m et sont distantes les unes des autres d'environ 20 à 50 *µ*m.

4. Composant de puissance comportant un substrat constitué d'une tranche de silicium faiblement dopé d'un premier type de conductivité opposé à celui d'un substrat faiblement dopé de tenue en tension, caractérisé en ce qu'il comprend du côté de sa face inférieure une succession de trous parallèles perpendiculaires à cette face inférieure et remplis d'un dopant du deuxième type de conductivité, et en ce que la périphérie du composant est également percée du côté de la face supérieure de trous remplis d'un dopant du deuxième type de conductivité, les zones diffusées se rejoignant à la périphérie du composant.
